(19) Europäisches Patentamt
European Patent Office
Office européen des brevets

(11) **EP 3 198 061 B1**

(12) **FASCICULE DE BREVET EUROPEEN**

(45) Date de publication et mention de la délivrance du brevet:
**26.12.2018 Bulletin 2018/52**

(21) Numéro de dépôt: **15766540.7**

(22) Date de dépôt: **22.09.2015**

(51) Int Cl.:
**C30B 11/00** (2006.01)    **C30B 29/06** (2006.01)

(86) Numéro de dépôt international:
**PCT/EP2015/071757**

(87) Numéro de publication internationale:
**WO 2016/046213 (31.03.2016 Gazette 2016/13)**

(54) **CREUSET POUR LA SOLIDIFICATION DIRECTIONNELLE DE SILICIUM MULTI-CRISTALLIN OU QUASI-MONOCRISTALLIN PAR REPRISE SUR GERME.**

SCHMELZTIEGEL ZUR GERICHTETEN ERSTARRUNG VON MULTI- KRISTALLINEM ODER QUASI-EINKRISTALLINEM SILIZIUM AUF KEIM(EN)

CRUCIBLE FOR DIRECTIONAL SOLIDIFICATION OF MULTI-CRYSTALLINE OR QUASI SINGLE CRYSTALLINE SILICON FROM SEEDS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2014   FR 1459148**

(43) Date de publication de la demande:
**02.08.2017   Bulletin 2017/31**

(73) Titulaire: **Commissariat à l'Énergie Atomique et aux Énergies Alternatives**
**75015 Paris (FR)**

(72) Inventeurs:
- **JOUINI, Anis**
  **F-73000 Chambery (FR)**
- **DREVET, Béatrice**
  **F-38000 Grenoble (FR)**
- **PLASSAT, Nelly**
  **F-73290 La Motte - Servolex (FR)**
- **PONTHENIER, Damien**
  **F-38800 Champagnier (FR)**
- **LAURENT, Julien**
  **F-73000 Chambery (FR)**

(74) Mandataire: **Nony**
**11 rue Saint-Georges**
**75009 Paris (FR)**

(56) Documents cités:
| | |
|---|---|
| EP-A1- 2 397 581 | EP-A1- 2 589 687 |
| CN-B- 101 935 869 | DE-A1-102012 100 147 |
| FR-A1- 2 935 618 | FR-A1- 2 979 638 |
| JP-A- 2006 219 336 | US-A1- 2007 089 642 |
| US-A1- 2011 104 036 | |

EP 3 198 061 B1

# Description

La présente invention se rapporte au domaine des creusets pour la fabrication, par solidification directionnelle, de lingots de silicium, notamment par reprise sur germe. Ces lingots de silicium peuvent être en silicium multi-cristallin, ou en silicium quasi-mono cristallin (également appelé silicium mono-like) ou encore en silicium multicristallin dit « HP » (en anglais « high performance multycristalline »). Un lingot de silicium multicristallin HP peut être obtenu par solidification dirigée avec reprise de cristallisation à partir d'une poudre ou des morceaux de silicium.

Les cellules photovoltaïques (PV) sont majoritairement fabriquées à partir de silicium mono- ou multicristallin, dans des filières qui mettent en jeu la solidification de lingots de silicium à partir d'un bain de silicium liquide contenu dans un creuset. Les lingots de silicium multi-cristallin y sont élaborés par fusion d'une charge de silicium suivie d'une solidification directionnelle. Ce procédé est très efficace pour cristalliser des grands volumes de silicium et la taille des lingots est modulable au regard de la dimension des creusets. En revanche, il ne donne pas totale satisfaction en termes de pureté.

En effet, le matériau constitutif de ces creusets est à forte concentration d'impuretés. Ainsi, les creusets utilisés pour la cristallisation de lingots de silicium multi-cristallin ou mono-like sont fabriqués généralement à partir de silice possédant en moyenne un taux de pureté de 99,6 %. Ces creusets possèdent donc des impuretés à un taux de l'ordre de 0,4 % en masse et représentées pour l'essentiel par des oxydes comme: $Al_2O_3$, $Fe_2O_3$, $TiO_2$, MgO, $Na_2O$, CaO et $K_2O$.

En outre, il est de pratique courante, à des fins de faciliter le démoulage du lingot de silicium solidifié, de déposer avant usage un revêtement anti-adhérent à base de nitrure de silicium ($Si_3N_4$) sur les parois intérieures du creuset. Or, le revêtement anti-adhérent en $Si_3N_4$ représente lui aussi une source de contamination.

En conséquence, le contact direct du silicium de très haute pureté (11 N) avec les parois intérieures du creuset revêtues par une poudre à base de $Si_3N_4$, toutes deux de moindre pureté que le silicium, est source de contamination du lingot final. Ce lingot est inévitablement contaminé par diffusion à l'état solide d'impuretés telles que Fe, Al, Cu, Co, Mn, Cr et la présence de ces impuretés dans la plaquette finale dégrade considérablement le rendement photovoltaïque final de la cellule solaire.

Cette pollution significative du lingot de silicium, se traduit en particulier sur une épaisseur de l'ordre de deux à trois centimètres d'épaisseur pour le multicristallin et de l'ordre de 3 à 5 centimètres pour le mono-like et le multicristallin HP, localisée dans la zone qui était au contact de la paroi de fond du creuset lors de la cristallisation du silicium fondu. Les propriétés électriques y sont fortement dégradées.

Cette zone encore dénommée « red-zone » (zone dont la durée de vie des porteurs minoritaires est inférieure à 2 µs) est constatée par plusieurs groupes industriels [Guerrero 2012].

Ce phénomène de contamination est encore plus préjudiciable lors de l'élaboration des lingots de silicium mono-like (ou quasi-mono) qui sont classiquement obtenus en solidifiant le silicium par épitaxie à partir de un ou plusieurs germes monocristallins de grande pureté, disposés au fond du creuset. En effet, dès la première utilisation, ces germes s'avèrent contaminés par la diffusion des impuretés métalliques et de l'oxygène provenant de l'ensemble creuset/revêtement anti-adhérent. Ils se trouvent alors intégrés dans les 30 % de la matière constitutive de la red zone, ce qui empêche leur réutilisation et augmente le coût des lingots mono-like.

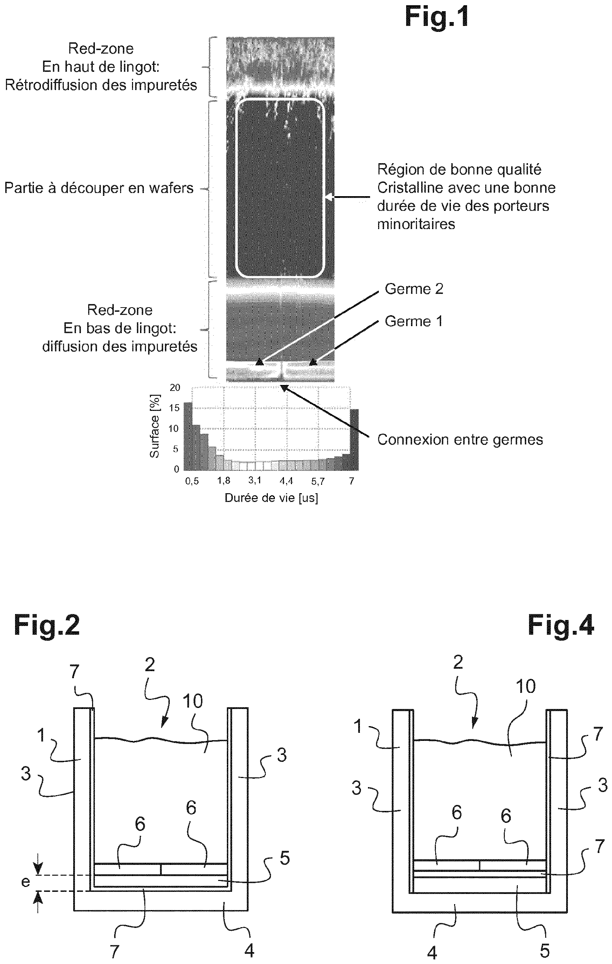

Un exemple de cartographie de la durée de vie des porteurs de charge sur une tranche découpée au milieu d'un lingot de silicium mono-like de taille G2 (40 cm × 40 cm × 17 cm) est illustré sur la figure 1. La partie basse du lingot affectée par la red-zone peut représenter autour de 30 % (18 kg) de la charge cristallisée (60 kg) et être inexploitable pour fabriquer des plaquettes.

[DE102012100147] présente un creuset pour la croissance de silicium monocristallin, comprenant un fond ayant une barrière de diffusion amovible en quartz.

La présente invention vise précisément à proposer un nouveau creuset pour la pour la fabrication par solidification dirigée d'un lingot de silicium notamment par reprise sur germe permettant de réduire significativement ce phénomène de contamination.

Plus précisément, l'invention porte sur un creuset adapté à la fabrication de lingots de silicium multicristallin ou quasi-mono-cristallin avantageusement dotés d'une partie basse de lingot dite encore « red-zone » (c.a.d. d'une zone dans laquelle la durée de vie des porteurs minoritaires est inférieure à 2 µs), qui est considérablement réduite en terme de volume. Au regard de cette diminution de la red-zone, le rendement en matière purifiée est accru.

Par ailleurs, la mise en oeuvre d'un creuset conforme à l'invention pour la cristallisation de silicium quasi-monocristallin par reprise sur germes est avantageusement propice à la réutilisation de ces germes.

Plus précisément la présente invention concerne un creuset pour la solidification directionnelle d'un lingot de silicium, comme décrit dans la revendication 1.

L'invention concerne aussi un procédé de solidification directionnelle d'un lingot de silicium à l'aide d'un creuset selon l'invention. Le procédé selon l'invention peut notamment comprendre au moins les étapes consistant à

a) disposer d'un moule dans lequel est ménagé au moins une cavité délimitée par des parois latérales et de fond destinées à constituer un support pour le moulage de silicium en fusion,
b) mettre en contact lesdites parois avec du silicium en fusion, et

c) soumettre ledit silicium à l'état fondu à des conditions propices à sa solidification dans ladite cavité, la solidification du silicium étant réalisée au contact, direct ou avoisinant, d'un élément amovible disposé entre ladite paroi de fond de ladite cavité et ledit silicium en fusion.

Par face interne du moule, on entend la face de la cavité du moule destinée à recevoir du silicium en fusion. A des fins de simplification de langage, le fond de la face interne du moule pourra être identifié ci-après en tant que « fond du moule ».

D'autres caractéristiques, avantages et modes d'application du creuset selon l'invention et du procédé selon l'invention, ressortiront mieux à la lecture de la description détaillée qui va suivre, de l'exemple de réalisation de l'invention et à l'examen des dessins annexés, sur lesquels :

- la figure 1 représente une cartographie de la durée de vie des porteurs de charge d'une tranche verticale d'un lingot de silicium mono-like de taille G2 de l'art antérieur,
- la figure 2 illustre une configuration de positionnement de l'élément barrière entre le fond du moule et le silicium à l'état fondu,
- la figure 3 représente un mode de réalisation particulier de l'élément barrière,
- la figure 4 illustre une variante de configuration de positionnement de l'élément barrière entre la paroi de fond du moule et le silicium à l'état fondu,
- la figure 5 représente sous forme d'un graphique la durée de vie des porteurs de charge en fonction de la hauteur de mesure à partir du bas du lingot, dans des lingots mono-like obtenus grâce à des creusets selon l'invention et selon l'art antérieur mis en oeuvre avec des conditions opérationnelles de procédé similaires.

Il convient de noter que, pour des raisons de clarté, les différents éléments sur les figures sont représentés en échelle libre, les dimensions réelles des différentes parties n'étant pas respectées.

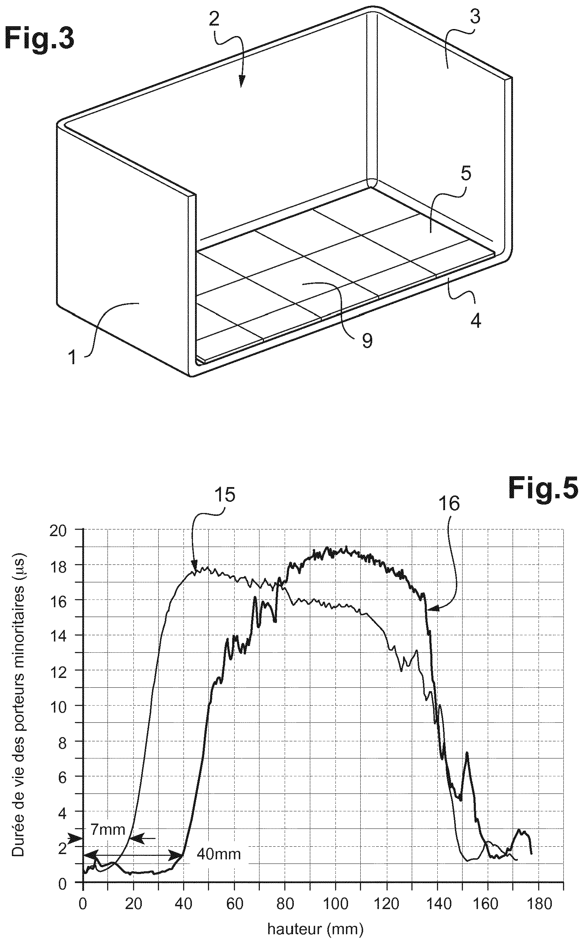

Comme cela est illustré sur les figures 1 à 3, un creuset 11 selon l'invention comporte un moule 1 destiné à recevoir du silicium en fusion 10. La cavité 2 du moule est délimitée par au moins une paroi verticale 3 et par un fond 4. Le creuset comporte en outre un élément amovible 5, disposé directement ou indirectement sur le fond du moule. Comme illustré sur les figures 2 et 3, le moule peut comporter des germes de silicium 6 disposés sur le fond de la cavité 2 du moule et l'élément amovible est interposé entre les germes de silicium et ledit fond. Par ailleurs, pour faciliter le démoulage du lingot après solidification et refroidissement, la cavité du moule peut être recouverte d'un revêtement anti-adhérent 7 avantageusement en nitrure de silicium dont au moins une partie est intercalée entre l'élément amovible 5 et le fond de la cavité. Comme cela est par exemple illustré sur la figure 1, le revêtement anti adhérent peut recouvrir entièrement le fond de la cavité ainsi qu'au moins partiellement, voire totalement les parois verticales de la cavité 3.

Comme il ressort des exemples qui suivent, le creuset selon l'invention permet de concentrer au niveau de l'épaisseur e de la couche barrière, les impuretés diffusant de la matière formant le fond du moule, voire du revêtement anti-adhérent si présent, en surface de cette paroi de fond. La contamination de la partie basse du lingot est, grâce à ce phénomène de rétention au niveau de la couche barrière, considérablement réduite.

Comme détaillé ci-après, l'épaisseur de la couche barrière est avantageusement au moins égale et de préférence supérieure à la distance de diffusion, d, calculée selon la convention

$$d = (D\,t)^{1/2}$$

dans laquelle D est le coefficient de diffusion maximal constaté parmi les impuretés présentes dans l'élément amovible et t est le temps passé à haute température lors du cycle thermique de cristallisation.

Comme énoncé précédemment, le creuset conforme à l'invention est formé d'un moule et d'un élément amovible formé en tout ou partie d'une couche dite barrière, dédiée à constituer une barrière de diffusion aux impuretés métalliques.

## ELEMENT AMOVIBLE

Pour constituer une barrière de diffusion aux impuretés métalliques (telles que Fe, Al, Cu, Co, Mn, Cr), le matériau constitutif de la couche barrière doit présenter une pureté en masse supérieure ou égale à 99,95 %, de préférence supérieure ou égale à 99,98 %, voire supérieure ou égale à 99,996 %, préférentiellement supérieure ou égale à 99,998 %.

Comme énoncé précédemment, le matériau formant la couche barrière est choisi parmi la silice $SiO_2$, le nitrure de silicium $Si_3N_4$, le carbure de silicium SiC, le carbonitrure de silicium, l'oxynitrure de silicium, le graphite et leurs mélanges.

La couche barrière peut être une combinaison de matériaux choisis dans la liste précitée. Notamment, il peut s'agir d'un mélange de plusieurs composés, à partir duquel est élaborée une couche barrière de composition homogène.

La couche barrière peut aussi être constituée par un empilement de revêtements, se superposant de préférence entièrement les uns aux autres, chaque revêtement étant en un matériau choisi dans la liste précitée. Les revêtements peuvent présenter une épaisseur identique. Dans une variante, les épaisseurs des revêtements peuvent être différentes. Par exemple, la couche barrière peut être constituée d'un empilement de deux revêtements, l'un des revêtements présentant une épaisseur au moins deux fois supérieure à l'autre.

Selon un premier mode de réalisation cette couche barrière constitue l'élément amovible.

Selon un second mode réalisation cette couche barrière ne forme qu'une partie de l'élément amovible.

Ainsi selon une première variante, la couche barrière peut être présente en surface d'un support et leur ensemble constitue l'élément amovible. Le support en surface duquel peut figurer la couche barrière est de préférence sous la forme d'une plaque support, revêtue au moins partiellement, voire de préférence totalement par la couche barrière.

Ainsi, l'élément amovible peut être formé d'au moins une plaque support en un matériau choisi parmi le silicium, le graphite ou un composite carbone/carbone, et leurs mélanges, et revêtue de ladite couche barrière, de préférence constituée de carbure de silicium SiC.

Ce support peut être en tout ou partie constitué par un germe de silicium et la couche barrière est alors préférentiellement déposée par CVD (Chemical Vapor Déposition) sur la face du germe en contact avec le fond du creuset. Un tel germe de silicium est avantageusement monocristallin et présente une densité de dislocations inférieure à 100 m$^{-2}$.

En variante, il peut être en tout ou partie constitué par un matériau constitué par le graphite, un composite carbone/carbone et leurs mélanges et la couche barrière peut alors avantageusement être déposée sur ledit support par CVD ou par CVI (Chemical Vapour Infiltration).

Selon une autre variante du second mode de réalisation, illustrée sur la figure 4, la couche barrière, déposée ou non sur un support, peut être revêtue en surface d'un revêtement anti-adhérent, permettant de faciliter le démoulage du lingot. En particulier, ce revêtement anti-adhérent peut être en un matériau présentant une pureté en masse au moins égale à la pureté en masse du matériau constitutif de la couche barrière. Ainsi, dans le cas où le revêtement anti-adhérent est disposé entre la couche barrière et le silicium en fusion, on évite une contamination du bain de silicium en fusion par les impuretés du revêtement anti-adhérent.

Un revêtement anti-adhérent adapté est en particulier constitué de nitrure de silicium de pureté en masse d'au moins 99,95 %, et obtenu par exemple par nitruration d'une poudre de silicium ultra pure.

En ce qui concerne la forme, les dimensions et la disposition de la couche barrière, elles sont d'une part propices à se superposer à l'intégralité de la surface de fond du moule et la couche barrière est dotée d'une épaisseur apte à agir comme barrière efficace tout au long de la cristallisation. De préférence, la longueur et la largeur de la couche barrière sont sensiblement égales à la longueur et à la largeur de l'élément amovible, respectivement.

Comme décrit ci-dessus, dans un mode de réalisation, la couche barrière peut être présente en surface d'un support se présentant sous la forme d'une plaque et leur ensemble constitue l'élément amovible. Dans ce cas, au moins une grande face du support est entièrement revêtue par la couche barrière. Le support ainsi revêtu constitue un élément amovible formant ainsi une barrière de diffusion composite. Lorsque seule une grande face du support est revêtue, il est avantageux que le support soit disposé entre la couche barrière et le fond du moule. On évite ainsi une éventuelle contamination du bain de silicium par le support.

Lorsque le support est en graphite et/ou en un composite carbone/carbone, il peut être avantageux que les deux grandes faces opposées du support, voire que le support entier soit revêtue par la couche barrière.

Dans le cas particulier où le support est un germe de silicium dont une grande face est recouverte par la couche barrière, la couche barrière est avantageusement disposée en regard du fond du moule. Un germe de silicium présente avantageusement une forme de pavé, de préférence, de section longitudinale carrée, dont un côté est avantageusement un multiple de 156 mm (soit un multiple d'une dimension standard actuelle d'une cellule photovoltaïque).

Dans une autre variante, où la couche barrière, déposée ou non sur un support, est recouverte d'un revêtement anti-adhérent, l'élément amovible peut être avantageusement disposé de telle sorte que la couche barrière est interposée entre le fond du moule et le revêtement anti-adhérent, le revêtement anti-adhérent étant en un matériau présentant une pureté au moins égale à celle du matériau formant la couche barrière.

Comme énoncé précédemment, l'épaisseur minimale de la couche barrière est pour sa part telle que la distance de diffusion des impuretés métalliques à haute température dans la plaque est bien inférieure à l'épaisseur de la couche barrière.

Cette distance de diffusion est d=(Dt)$^{1/2}$ dans laquelle D est le coefficient de diffusion de l'impureté considérée dans le matériau constitutif de la plaque, et t le temps passé à haute température lors du cycle thermique de cristallisation.

Ainsi, pour un lingot de taille G2, le temps passé entre 1000 °C et 1412 °C (température de fusion du silicium) est d'environ 40 h.

Le coefficient de diffusion du fer dans SiO$_2$ à 1400 °C est de l'ordre de 10$^{-11}$ cm$^2$/s [Istratov 2005], ce qui conduit à une distance de diffusion de 12 microns après 40 h.

Le coefficient de diffusion du fer dans SiC à 1400 °C est de l'ordre de 2,5 10$^{-13}$ cm$^2$/s [Lee 1997], ce qui conduit à une distance de diffusion de 2 microns après 40 h.

Dans ce cas d'espèce, la couche barrière présente donc de préférence une épaisseur supérieure aux distances calculées dans les exemples ci-dessus.

L'épaisseur de la couche barrière peut être comprise entre 1 et 20 mm, préférentiellement entre 2 et 5 mm, avantageusement lorsque l'élément amovible est constitué par la couche barrière.

Dans la variante où l'élément amovible comporte un support, par exemple un germe de silicium ou une plaque support en graphite et/ou en composite carbone/carbone, et revêtu par une couche barrière, l'épaisseur de la couche barrière est de préférence comprise entre 20 μm et 500 μm, en particulier dans le cas où ladite couche barrière est déposée par CVD. En variante, une couche barrière dont le matériau constitutif est déposé par CVI peut avantageusement présenter une épaisseur comprise entre 20 μm et 100 μm.

Comme énoncé précédemment, cette couche barrière, disposée ou non sur un support, est disposée dans le creuset selon l'invention pour s'intercaler entre le silicium fondu 10 et le fond du moule 4 contenant ce silicium fondu.

Dans le cas où le procédé de solidification dirigée est opéré par reprise sur germes de silicium, les germes de silicium sont de préférence intercalés entre le bain de silicium fondu et la couche barrière. Ainsi, la couche barrière peut empêcher la diffusion des impuretés du moule vers les germes de silicium. Il est alors possible de réutiliser les germes pour fabriquer un ou plusieurs lingots.

Plusieurs alternatives d'élément amovible en termes de forme conviennent à l'invention. Comme cela apparaitra par la suite, l'élément amovible peut être disposé directement ou indirectement sur le fond du moule.

Selon une première variante, comme cela est par exemple illustré sur la figure 2, l'élément amovible 5 est monolithique, c'est-à-dire formé d'un seul élément. Il peut par exemple s'agir d'une plaque ou encore d'un pavé. Sur la figure 2, les dimensions en largeur et en longueur de cet élément amovible monolithique sont sensiblement égales à celles du fond 4 du creuset de sorte qu'il couvre la quasi-totalité du fond du creuset 4.

Ce type d'élément est avantageusement plan sur sa face supérieure et épouse la forme du fond du moule dans le cas d'un moule de surface lisse, c'est-à-dire qui présente une variation totale d'épaisseur inférieure à 200 μm. De préférence, la variation d'épaisseur de la plaque est alors inférieure à 200 μm.

Selon une seconde variante, l'élément amovible est défini par une pluralité d'éléments assemblés définissant chacun une portion de la surface de la paroi de fond 4. Ces éléments peuvent notamment être disposés selon un réseau régulier ou non. Ce mode de réalisation peut être tout particulièrement avantageux dans le cas où l'élément amovible peut être utilisé dans des moules de dimensions variables. Ainsi, un élément amovible dont la surface peut être modulée via le nombre d'éléments disposés les uns par rapports aux autres, pourra avantageusement être considéré pour des creusets de dimensions variables.

Dans une autre variante de réalisation, le creuset selon l'invention peut comporter plusieurs éléments amovibles de plus petites dimensions et disposées de manière adjacente et jointives. Ces éléments amovibles peuvent notamment être disposés selon un réseau régulier ou non.

Un tel creuset est en outre particulièrement intéressant pour la fabrication de lingot de silicium préparé à partir de germes de cristallisation. Dans ce cas d'espèce, le ou les germes de cristallisation 6, le plus souvent de silicium, sont directement disposés au contact de l'élément amovible. Les germes peuvent être sous forme de pavés de sorte à former un lingot de silicium de type mono-like, ou sous forme d'une poudre de silicium et/ou des morceaux de silicium en vue de former un lingot de silicium de type multicristallin « HP ». Comme illustré en figure 2, de par sa localisation en dessous des germes 6, l'élément amovible 5 et notamment la couche barrière joue le rôle de barrière de diffusion des impuretés de l'ensemble moule/revêtement anti-adhérent vers le lingot de silicium. Il s'en suit une contamination significativement réduite voire nulle des germes, qui peuvent être alors avantageusement réutilisés pour une nouvelle cristallisation de silicium fondu.

Dans une variante correspondant à une solidification par reprise sur germe, avec un pavage de germes, le ou les éléments amovible(s) peuvent comporter un ou plusieurs évidements conformés pour recevoir un germe de silicium. Il peut notamment se présenter sous forme d'une plaque conçue pour accueillir les germes avec des emplacements adaptés, comme cela peut être observé sur la figure 3. Ainsi, la plaque peut contenir des cavités 9 dans lesquelles seront disposés les germes 6. Les germes peuvent ainsi être maintenus en place une fois disposés dans les cavités tout au long de la solidification dirigée du lingot de silicium.

La plaque peut également être en plusieurs parties, chaque partie étant disposée sous un ou plusieurs germes.

Il est à noter que, quelle que soit la forme de l'élément amovible, pour pallier un défaut de planéité de la face inférieure du fond de moule, le creuset peut comporter une couche d'accommodation de la planéité du fond de la cavité du moule, formée d'une poudre de particules ayant une taille de grain inférieure à 500 microns, les particules étant en un matériau choisi parmi Si, $Si_3N_4$, SiC, C, $SiO_2$ et leurs mélanges. L'addition d'une telle poudre fine, de préférence de forme sphérique, au fond du moule permet d'obtenir une surface parfaitement plane.

Cette option est tout particulièrement intéressante pour assurer un parallélisme parfait dans le cas de la mise en oeuvre de germes de cristallisation. Elle permettra d'éviter la création de dislocations dans le silicium solidifié au regard des joints entre les germes. La température de fusion de cette poudre devrait être supérieure à 1400 °C.

Dans pareil cas où une poudre est mise en oeuvre, l'élément amovible est alors indirectement au contact du fond du moule.

Quelle que soit la variante de forme considérée pour l'élément amovible, son épaisseur maximale est de préférence telle que l'on n'affecte pas significativement le rendement matière lors de la cristallisation des lingots de silicium. Notamment, pour conserver une extraction efficace de la chaleur hors du lingot en cours de solidification, il est intéressant de privilégier une hauteur de lingot n'excédant pas environ 350 mm.

Ainsi, de manière avantageuse, l'épaisseur de l'élément amovible, en particulier se présentant sous la forme d'une plaque, est généralement supérieure ou égale à 20 $\mu$m, de préférence supérieure ou égale à 1 mm, de préférence supérieure ou égale à 2 mm et inférieure ou égale à 25 mm, préférentiellement inférieure ou égale à 20 mm, préférentiellement inférieure ou égale à 5 mm.

Par ailleurs, l'épaisseur de l'élément amovible est telle que l'élément amovible est généralement suffisamment rigide pour être manipulé sans rompre sous son propre poids.

## MOULE

Le moule est compatible avec un chauffage à une température supérieure ou égale à la température de fusion du silicium, notamment comprise entre 1 450 °C et 1 550 °C.

Avantageusement du silicium à l'état solide peut être présent au sein de la cavité. Dans ce cas, l'étape de solidification dirigée peut être réalisée en portant ledit silicium à l'état solide à une température permettant sa fusion.

Selon une variante le moule est tel que du silicium peut être incorporé à l'état fondu au sein de ladite cavité.

Le moule peut être monolithique ou être multiblocs, c'est-à-dire constitué de plusieurs blocs conformés pour former le moule par assemblage.

Il peut être constitué en un matériau choisi parmi la silice, le graphite, le carbure de silicium, le nitrure de silicium, un composite carbone/carbone et leurs mélanges. Avantageusement, la pureté en masse du matériau constitutif du moule peut être inférieure à 99,9 % et/ou supérieure 99,6 %.

La cavité du moule est en particulier de forme trapézoïdale à section carrée. La cavité du moule, en particulier lorsque celui-ci est monolithique, peut présenter une forme évasée avec un angle de dépouille pour faciliter le démoulage des lingots, cet angle étant de préférence inférieur à 10° pour éviter une perte de matière trop élevée pour la découpe du lingot en plaquettes.

La cavité du moule peut être recouverte d'un revêtement anti-adhérent, de préférence en nitrure de silicium, et pouvant être déposé directement sur le fond du moule. De préférence, l'élément amovible est alors disposé sur le revêtement anti-adhérent. Autrement dit, au moins une partie du revêtement anti adhérent est disposé entre l'élément amovible et le fond de la cavité du moule.

Il est à noter qu'un tel revêtement anti-adhérent en fond de moule est optionnel dans le cadre de la croissance de lingots de silicium quasi mono-cristallin.

Les exemples et figures présentés ci-après, sont soumis à titre illustratif et non limitatif du domaine de l'invention.

## Exemples

Deux exemples de cristallisation par reprise sur germes sont réalisés dans un four de solidification dirigée en utilisant un cycle thermique identique pour les étapes suivantes : chauffage, fusion de la charge de silicium, cristallisation et refroidissement du lingot.

Les creusets utilisés sont à base de silice, présentant une pureté en masse supérieure à 99,6 %, et sont revêtus d'un revêtement anti-adhérent à base de $Si_3N_4$, la teneur en $Si_3N_4$ du revêtement étant supérieure à 99,98 %.

Le lingot du premier exemple est obtenu en plaçant des germes directement sur le fond du creuset revêtu du revêtement anti-adhérent, tandis que pour le deuxième exemple, une plaque de fond de 5 mm d'épaisseur et en silice présentant une pureté en masse supérieure à 99,998 %, est intercalée entre le revêtement anti-adhérent et les germes, comme cela est illustré sur la figure 2.

Après démoulage des lingots, une mesure de durée de vie des porteurs minoritaires est effectuée sur une tranche verticale découpée au centre des lingots, de façon notamment à mesurer la taille de la red zone inexploitable.

Les mesures, présentées sur la figure 5, indiquent que l'épaisseur de la red zone de 40 mm pour le premier exemple (courbe 16), est réduite à 17 mm pour le deuxième exemple (courbe 15), soit une réduction de taille de 57 %.

## Références

[Guerrero 2012] "About the origin of low wafer performance and crystal defect generation on seed-cast growth of industrial mono-like silicon ingots", Ismael Guerrero, Vicente Parra, Teresa Carballo, Andrés Black, Miguel Miranda, David Cancillo, Benito Moralejo, Juan Jiménez, Jean-François Lelièvre and Carlos del Cañizo, Progress in Photovoltaïcs: Research and Applications, Prog. Photovolt: Res. Appl. (2012)

[Istratov 2005] "Gettering in silicon-on-insulator wafers : experimental studies and modelling", A.A. Istratov et al., Semicond. Sci. Technol., 20, 568-575 (2005)

[Lee 1997] "Impurity diffusion in beta-SiC", C.G. Lee, Y. Iijima, (1997)

[DE102012100147] "VERFAHREN ZUR HERSTELLUNG VON MONO-, QUASIMONO- ODER MULTIKRISTALLINEN METALL- ODER HALBMETALLKÖRPERN", M. Müller, D. Jockel, F. KROPFGANS

## Revendications

1. Creuset pour la solidification directionnelle d'un lingot de silicium, ledit creuset comportant un moule (1) destiné à recevoir du silicium en fusion, et un élément amovible (5) formant barrière de diffusion aux impuretés métalliques et disposé sur le fond (4) de la face interne dudit moule, l'élément amovible étant formé en tout ou partie d'une couche barrière formée par au moins un matériau choisi dans le groupe constitué par la silice $SiO_2$, le nitrure de silicium $Si_3N_4$, le carbure de silicium SiC, le carbonitrure de silicium, l'oxynitrure de silicium, le graphite et leurs mélanges et présentant une pureté d'au moins 99,95 % en masse, la couche barrière présentant une épaisseur propice à la rétention des impuretés susceptibles de diffuser hors du fond (4) pendant la solidification directionnelle et le refroidissement du silicium, la cavité du moule étant recouverte d'un revêtement anti-adhérent (7) avantageusement en nitrure de silicium dont au moins une partie est intercalée entre l'élément amovible (5) et le fond de la cavité.

2. Creuset selon la revendication 1, dans lequel l'épaisseur de la couche barrière est supérieure ou égale à 20 $\mu$m, de préférence supérieure ou égale à 1 mm, de préférence supérieure ou égale à 2 mm et inférieure ou égale à 25 mm, de préférence inférieure ou égale à 20 mm, de préférence inférieure ou égale à 5 mm.

3. Creuset selon l'une quelconque des revendications 1 et 2, **caractérisé en ce que** l'élément amovible est constitué par la couche barrière.

4. Creuset selon l'une quelconque des revendications 1 et 2, **caractérisé en ce que** l'élément amovible est formé d'au moins un support en un matériau choisi parmi le silicium, le graphite ou un composite carbone/carbone, et leurs mélanges, et revêtu de ladite couche barrière, de préférence en carbure de silicium.

5. Creuset selon la revendication précédente, l'épaisseur de la couche barrière étant comprise entre 20 $\mu$m et 500 $\mu$m.

6. Creuset selon l'une quelconque des revendications précédentes, dans lequel des germes de silicium sont disposés sur le fond de la cavité du moule et l'élément amovible (5) est interposé entre les germes de silicium et ledit fond.

7. Creuset selon l'une quelconque des revendications précédentes, comportant une couche d'accommodation de la planéité du fond de la cavité du moule, formée d'une poudre de particules ayant une taille de grain inférieure à 500 microns, les particules étant en un matériau choisi parmi Si, $Si_3N_4$, SiC, C, $SiO_2$ et leurs mélanges.

8. Creuset selon l'une quelconque des revendications précédentes, dans le lequel le moule est constitué par un matériau choisi parmi la silice, le graphite, le carbure de silicium, le nitrure de silicium un composite carbone/carbone et leurs mélanges.

9. Procédé de solidification directionnelle d'un lingot de silicium à l'aide d'un creuset selon l'une quelconque des revendications 1 à 8.

## Patentansprüche

1. Schmelztiegel zur gerichteten Erstarrung eines Siliziumstabes, wobei der Schmelztiegel eine Form (1), die dazu bestimmt ist, geschmolzenes Silizium aufzunehmen, und ein abnehmbares Element (5) umfasst, das eine Diffusionsbarriere für die metallischen Verunreinigungen bildet und am Boden (4) der Innenseite der Form angeordnet ist, wobei das abnehmbare Element zur Gänze oder teilweise von einer Barriereschicht gebildet ist, die von mindestens einem Material gebildet ist, das in der Gruppe ausgewählt ist, umfassend Siliziumoxid $SiO_2$, Siliziumnitrid $Si_3N_4$, Siliziumkarbid SiC, Siliziumkarbonitrid, Siliziumoxinitrid, Graphit und ihre Mischungen mit einer Reinheit von mindestens 99,95 Massen-%, wobei die Barriereschicht eine Dicke aufweist, die für die Retention der Verunreinigungen, die aus dem Boden (4) während der gerichteten Erstarrung diffundieren können, und die Kühlung des Siliziums geeignet ist, wobei der Hohlraum der Form mit einer Antihaftverkleidung (7) vorteilhafterweise aus Siliziumnitrid überzogen ist, die mindestens zum Teil zwischen dem abnehmbaren Element (5) und dem Boden des Hohlraums zwischengefügt ist.

2. Schmelztiegel nach Anspruch 1, bei dem die Dicke der Barriereschicht größer oder gleich 20 $\mu$m, vorzugsweise größer oder gleich 1 mm, vorzugsweise größer oder gleich 2 mm und kleiner oder gleich 25 mm, vorzugsweise kleiner oder gleich 20 mm, vorzugsweise kleiner oder gleich 5 mm ist.

3. Schmelztiegel nach einem der Ansprüche 1 und 2, **dadurch gekennzeichnet, dass** das abnehmbare Element von der Barriereschicht gebildet ist.

**4.** Schmelztiegel nach einem der Ansprüche 1 und 2, **dadurch gekennzeichnet, dass** das abnehmbare Element von mindestens einem Träger aus einem Material gebildet ist, das unter Silizium, Graphit oder einem Kohlenstoff-/Kohlenstoff-Verbundmaterial und ihren Mischungen ausgewählt ist, und mit der Barriereschicht, vorzugsweise aus Siliziumkarbid, überzogen ist.

**5.** Schmelztiegel nach dem vorhergehenden Anspruch, wobei die Dicke der Barriereschicht zwischen 20 $\mu$m und 500 $\mu$m beträgt.

**6.** Schmelztiegel nach einem der vorhergehenden Ansprüche, bei dem Siliziumkeime am Boden des Hohlraums der Form angeordnet werden, und das abnehmbare Element (5) zwischen den Siliziumkeimen und dem Boden zwischengefügt ist.

**7.** Schmelztiegel nach einem der vorhergehenden Ansprüche, umfassend eine Schicht zur Anpassung der Planheit des Bodens des Hohlraums der Form, gebildet von einem Partikelpulver mit einer Korngröße unter 500 Mikrometer, wobei die Partikel aus einem Material, ausgewählt unter Si, $Si_3N_4$, SiC, C, $SiO_2$ und ihren Mischungen, sind.

**8.** Schmelztiegel nach einem der vorhergehenden Ansprüche, bei dem die Form von einem Material gebildet ist, das unter Siliziumoxid, Graphit, Siliziumkarbid, Siliziumnitrid, einem Kohlenstoff-/Kohlenstoff-Verbundmaterial und ihren Mischungen ausgewählt ist.

**9.** Verfahren zur gerichteten Erstarrung eines Siliziumstabs mit Hilfe eines Schmelztiegels nach einem der Ansprüche 1 bis 8.

**Claims**

**1.** Crucible for the directional solidification of a silicon ingot, the said crucible comprising a mould (1) intended to receive molten silicon, and a removable element (5) forming a diffusion barrier to the metal impurities and positioned on the bottom (4) of the internal face of the said mould, the removable element being formed, in all or part, of a barrier layer formed by at least one material chosen from the group consisting of silica $SiO_2$, silicon nitride $Si_3N_4$, silicon carbide SiC, silicon carbonitride, silicon oxynitride, graphite and their mixtures and exhibiting a purity of at least 99.95% by weight, the barrier layer exhibiting a thickness favourable to the retention of the impurities liable to diffuse out of the bottom (4) during the directional solidification and the cooling of the silicon, the cavity of the mould being covered with a nonstick coating (7) advantageously made of silicon nitride, at least a portion of which is inserted between the removable element (5) and the bottom of the cavity.

**2.** Crucible according to Claim 1, in which the thickness of the barrier layer is greater than or equal to 20 $\mu$m, preferably greater than or equal to 1 mm, preferably greater than or equal to 2 mm, and less than or equal to 25 mm, preferably less than or equal to 20 mm, preferably less than or equal to 5 mm.

**3.** Crucible according to either one of Claims 1 and 2, **characterized in that** the removable element consists of the barrier layer.

**4.** Crucible according to either one of Claims 1 and 2, **characterized in that** the removable element is formed of at least one support made of a material chosen from silicon, graphite or a carbon/carbon composite, and their mixtures, and coated with the said barrier layer, preferably made of silicon carbide.

**5.** Crucible according to the preceding claim, the thickness of the barrier layer being between 20 $\mu$m and 500 $\mu$m.

**6.** Crucible according to any one of the preceding claims, in which silicon seeds are positioned on the bottom of the cavity of the mould and the removable element (5) is inserted between the silicon seeds and the said bottom.

**7.** Crucible according to any one of the preceding claims, comprising a layer for accommodating the flatness of the bottom of the cavity of the mould, which layer is formed of a powder of particles having a grain size of less than 500 microns, the particles being made of a material chosen from Si, $Si_3N_4$, SiC, C, $SiO_2$ and their mixtures.

**8.** Crucible according to any one of the preceding claims, in which the mould consists of a material chosen from silica, graphite, silicon carbide, silicon nitride, a carbon/carbon composite and their mixtures.

**9.** Process for the directional solidification of a silicon ingot using a crucible according to any one of Claims 1 to 8.

# Fig.1

Red-zone
En haut de lingot:
Rétrodiffusion des impuretés

Partie à découper en wafers

Région de bonne qualité
Cristalline avec une bonne
durée de vie des porteurs
minoritaires

Red-zone
En bas de lingot:
diffusion des impuretés

Germe 2

Germe 1

Connexion entre germes

Surface [%]

Durée de vie [us]

# Fig.2

# Fig.4

# Fig.3

# Fig.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102012100147

**Littérature non-brevet citée dans la description**

- **ISMAEL GUERRERO ; VICENTE PARRA ; TERESA CARBALLO ; ANDRÉS BLACK ; MIGUEL MIRANDA ; DAVID CANCILLO ; BENITO MORALEJO ; JUAN JIMÉNEZ ; JEAN-FRANÇOIS LELIÈVRE ; CARLOS DEL CAÑIZO.** About the origin of low wafer performance and crystal defect generation on seed-cast growth of industrial mono-like silicon ingots. *Progress in Photovoltaïcs: Research and Applications, Prog. Photovolt: Res. Appl.,* 2012

- **A.A. ISTRATOV et al.** Gettering in silicon-on-insulator wafers : experimental studies and modelling. *Semicond. Sci. Technol.,* 2005, vol. 20, 568-575
- **C.G. LEE ; Y. IIJIMA.** *Impurity diffusion in beta-SiC,* 1997